# FASCICULE DE BREVET EUROPEEN

(11) **EP 1 062 634 B1**
(45) Date de publication et mention de la délivrance du brevet: **12.08.2009**
(21) Numéro de dépôt: 00900614.9
(22) Date de dépôt: 19.01.2000
(51) Int. Cl.: G06K 19/077

(54) **CARTE A PUCE MUNIE D'UNE ANTENNE EN BOUCLE, ET MICROMODULE ASSOCIE**
CHIPKARTE MIT EINER SCHLEIFENANTENNE UND ZUGEHÖRIGES MIKROMODUL
CHIP CARD EQUIPPED WITH A LOOP ANTENNA, AND ASSOCIATED MICROMODULE

(30) Priorité: 19.01.1999 FR 9900486
(43) Date de publication de la demande: 27.12.2000
(73) Titulaire: CP8 TECHNOLOGIES, 78431 Louveciennes (FR)
(72) Inventeur: CARPIER, Roland, F-78180 Montigny le Bretonneux (FR); LAUVERNIER, Christine, F-78380 Bougival (FR); LE LOC'H, Alain, F-78000 Versailles (FR)
(74) Mandataire: Cassagne, Philippe M.J.
(86) Numéro de dépôt international: PCT/FR2000/000110
(87) Numéro de publication internationale: WO 2000/043951

(56) Documents cités:
- WO-A-97/34247
- DE-C- 19 632 115
- US-A- 5 671 525

## Description

La présente invention concerne une carte à puce munie d'une antenne en boucle ouverte, notamment une carte à puce du type dit "à connexions mixtes", qui sera définie ci-après.

Dans le cadre de l'invention, le terme "carte" doit être compris dans son sens le plus général : carte à mémoire ("CAM"), carte à "puce", etc.

En ce qui concerne le mode de communication avec le monde extérieur, il existe deux grandes catégories de cartes à puce : des cartes à puce avec et sans contacts. Dans le second cas, diverses méthodes peuvent être utilisées. On peut faire appel, notamment, à un couplage optique ou un couplage électromagnétique à l'aide d'une antenne en boucle spiralée. Dans le cadre de l'invention, on s'intéressera à ce second type de couplage.

La majorité des cartes à puce sont du premier type, c'est-à-dire à contacts. Ces cartes à puce sont fabriquées à partir de "micromodules", c'est-à-dire des ensembles comprenant un circuit imprimé ou une grille métallique présentant des contacts contre lesquels sont collés et câblés des composants de type circuits intégrés : mémoires, micro-processeurs, micro-contrôleurs, etc. Ces composants sont ensuite protégés par une résine d'enrobage de façon à rendre les micromodules utilisables pour l'opération finale d'encartage. Cette dernière consiste à coller les micromodules dans un support plastique comportant une cavité destinée à recevoir ce micromodule.

Les cartes du deuxième type, dites "sans contacts", sont couplées avec le milieu extérieur par induction électromagnétique. Les fréquences utilisées se répartissent dans deux gammes : une gamme basses fréquences, la fréquence nominale étant typiquement de 125 kHz, et une gamme hautes fréquences, la fréquence nominale étant typiquement de 13,56 MHz. Pour ce faire, on prévoit une antenne qui se présente habituellement sous la forme d'une boucle spiralée, connectée à ses extrémités au micromodule précité. Pour obtenir une sensibilité suffisante, il est nécessaire de prévoir une antenne comportant une centaine de spires, si l'on travaille à basse fréquence, et 2 à 3 spires si l'on travaille à haute fréquence.

Les technologies actuelles mises en oeuvre pour la fabrication de cartes à puce permettent d'intégrer les antennes précitées dans le matériau de la carte à puce, plus précisément entre deux couches de matériau plastique. Les spires sont en effet disposées sur des couches en matériau plastique de type "PVC" ou "PET". Les couches métalliques peuvent être imprimées sur le plastique (par exemple par sérigraphie) ou réalisées par dépôt d'un fil métallique, directement réalisé par soudure thermique sur la couche plastique.

Il existe enfin des cartes à puce dites "mixtes", qui constituent le domaine d'application préféré de l'invention. Ce type de cartes à puce présente l'avantage de permettre un accès, à la fois via des contacts "classiques", ce qui permet de les utiliser dans des lecteurs standards, ou par passage à proximité d'organes émetteurs-récepteurs appropriés, les micromodules comprenant une interface à haute fréquence. Le terme "lecteur" doit être compris dans un sens général, c'est-à-dire un appareil permettant la lecture et/ou l'écriture d'informations numériques dans une carte à puce.

Dans ce qui suit, on se placera dans cette application préférée, c'est-à-dire dans le cas d'une carte à puce "mixte".

Généralement, les cartes à puce sont standardisées et respectent des normes, tant d'un point de vue électrique que mécanique, notamment les normes suivantes :
ISO 7816 pour les cartes à puce à contacts,
ISO 14443 pour les cartes sans contacts, de proximité.

Dans ce dernier cas, la fréquence utilisée est généralement égale à 13,56 MHz, ce qui réduit l'encombrement de l'antenne, celle-ci ne comportant plus que deux ou trois spires.

La disponibilité de composants pour cartes à puce "mixte" amène à concevoir de nouveaux procédés d'assemblage. En gardant à l'esprit que ce type de composant est l'objet d'une production de masse, il est nécessaire que le prix de revient final soit le plus bas possible. Par ailleurs, il est également nécessaire d'obtenir une grande fiabilité, comme dans le cas d'une carte à puce classique à contacts.

Pour toutes ces raisons, il est donc souhaitable de continuer à utiliser, autant que faire se peut, des procédés d'assemblage et des technologies de l'art connu qui ont fait leurs preuves. Parmi ces procédés, on peut citer, de façon non exhaustive :
- l'assemblage du micromodule semi-conducteur sur un support de type circuit imprimé, muni de plages de contact galvaniques ;
- la fabrication du support en matériau plastique de la carte à puce proprement dite, par pressage d'un empilement de couches en matériau plastique ; et
- l'encartage par collage du micromodule dans une cavité du support en matériau plastique.

Il reste cependant nécessaire de connecter le composant semi-conducteur, ou "chip", à l'antenne, et plus précisément aux extrémités de l'antenne, ce qui pose un problème spécifique. La connexion est effectuée via des plots de connexion qui doivent être reliés aux extrémités précitées.

Dans l'art connu, on a proposé de réaliser cette connexion à l'aide d'un circuit imprimé double face, c'est-à-dire comportant des pistes métallisées, par exemple en cuivre, de part et d'autre d'un support isolant. Le support est alors un circuit imprimé double face. Cette solution présente comme inconvénient un coût élevé. De ce fait, elle ne répond pas au moins à l'une des exigences rappelées.

En outre, même si une fréquence élevée est utilisée (typiquement 13,56 MHz), l'antenne est constituée d'une boucle ouverte comprenant généralement au moins deux ou trois spires. Il existe donc nécessairement, à un endroit ou à un autre de la surface de la carte à puce, un croisement de deux pistes conductrices, à l'aplomb l'une de l'autre. Il s'ensuit que l'on doit prévoir une zone isolante et un "pont" conducteur entre deux sections d'antenne.

L'invention se fixe donc pour objet principal une connectique optimisée permettant de relier des plots conducteurs du micromodule de la carte à puce, aux extrémités de l'antenne. Elle permet, notamment, de minimiser le nombre de couches de métal, soit au niveau du micromodule, soit encore au niveau de l'antenne. Elle s'applique préférentiellement aux carte à puce de type "mixte".

Pour ce faire, selon une caractéristique importante de l'invention, on utilise la face active du support portant le composant semi-conducteur intégré, c'est-à-dire côté plages de contact, pour établir des connexions électriques entre des entrées-sorties du composant et des terminaisons d'antenne de couplage.

Dans un second mode de réalisation, on utilise également des plages de contact de la face active du support pour établir des connexions électriques entre des portions d'antenne.

L'invention est définie par les revendications 1 et 2.

L'invention concerne enfin un procédé de fabrication d'une carte à puce comportant une antenne présentant deux extrémités, à partir d'au moins deux couches en une matière électriquement isolante, et d'un micromodule comprenant un support électriquement isolant portant, dans une région centrale et sur une première face, un composant semi-conducteur et, dans une région périphérique et sur la première face ou une seconde face, deux plages de contact reliées à deux bornes d'entrée/sortie d'antenne du composant semi-conducteur, les plages de contact étant disposées de façon telle qu'une fois le micromodule appliqué sur la carte, les deux plages de contact se trouvent en face desdites extrémités de l'antenne, comprenant les étapes suivantes :
- préparer une première couche portant, sur une face, ladite antenne ;
- préparer un seconde couche présentant deux trous traversants disposés de façon telle qu'une fois la seconde couche appliquée sur la face de la première couche portant l'antenne, lesdits trous se trouvent en face desdites extrémités de l'antenne ;
- appliquer et fixer la seconde couche sur la face de la première couche portant l'antenne ;
- appliquer le micromodule sur la carte de façon que son composant semi-conducteur soit logé dans une cuvette centrale ménagée dans la carte, et que sa région périphérique soit logée dans une cuvette périphérique disposée autour de la cuvette centrale ;
- relier entre elles les plages de contact du micromodule et les extrémités de l'antenne.

L'invention sera mieux comprise et d'autres caractéristiques et avantages apparaîtront à la lecture de la description qui suit en référence aux figures annexées, parmi lesquelles :
- la figure 1 illustre schématiquement un exemple de réalisation d'un micromodule côté composant ;
- les figures 2A à 2C illustrent, respectivement, une carte à puce munie d'une antienne connectée à un micromodule, un micromodule du type de la figure 1, en vue de dessous, et cette même carte à puce, en vue de côté et coupe selon AA de la figure 2A ;
- les figures 3A et 3B illustrent, respectivement, une carte à puce munie d'une antenne connectée à un micromodule et cette même carte à puce, en vue de côté et coupe selon AA de la figure 3A, selon une variante de réalisation supplémentaire ;
- les figures 4A et 4B illustrent, respectivement, une carte à puce munie d'une antenne connectée à un micromodule et cette même carte à puce, en vue de côté et coupe selon AA de la figure 4A, selon une deuxième variante de réalisation supplémentaire ;
- les figures 5A et 5B illustrent, respectivement, une carte à puce munie d'une antenne connectée à un micromodule et cette même carte à puce, en vue de côté et coupe selon AA de la figure 5C, selon une troisième variante de réalisation supplémentaire ;
- la figure 5C illustre, en vue de dessus, un micromodule modifié pour convenir à la troisième variante de réalisation supplémentaire ; et
- la figure 6 représente une variante de réalisation d'un micromodule, côté plages de contact.

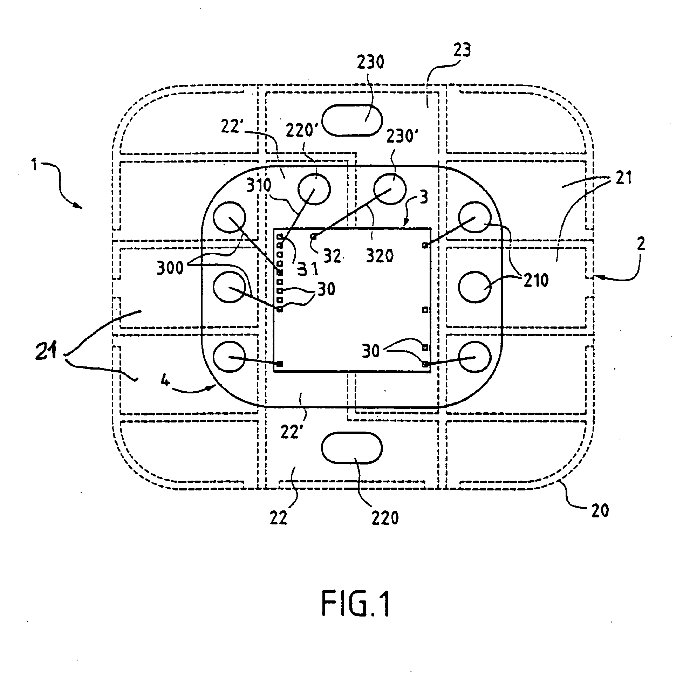

La figure 1 illustre schématiquement un exemple de micromodule 1 utilisable dans le cadre de l'invention. En réalité, celui-ci comprend deux parties principales. Le micromodule 1 est vu de dessous, c'est-à-dire du côté opposé aux plages de contacts électriques.

La première partie est constituée par la "puce" électronique 3 proprement dite, c'est-à-dire un composant semi-conducteur intégré, généralement de forme parallélépipédique rectangle et de faible épaisseur, par exemple un microprocesseur ou équivalent. Le microprocesseur 3 comporte des pattes ou bornes d'entrées-sorties 30, disposées en périphérie. La configuration, la fonction et le nombre de ces entrées-sorties dépend naturellement du composant précis 3 mis en oeuvre. Le microprocesseur 3 comprend notamment deux bornes d'entrées-sorties spécifiques, 31 et 32, généralement contigües et communiquant avec une interface dite "HF" (non représentée).

La seconde partie consiste en un support 2 constitué d'un circuit imprimé simple face 20, sur lequel est collé, dans une région centrale, le composant semi-conducteur 3. Le support comprend deux rangées de plages conductrices 21 disposées en périphérie (représentées en traits pointillés, car disposées sur la face de dessus), ces rangées étant distantes l'une de l'autre et séparées par une zone s'étendant selon une forme de bande passant par la région centrale du support. Chaque rangée comprend cinq plages conductrices 21 disposées en ligne. Le nombre et la configuration des plages conductrices 21 obéit généralement aux normes ISO précitées. Les connexions nécessaires entre les plots 30 et les plages 21 sont assurées, classiquement, par de minces fils conducteurs 300. De façon plus précise, on prévoit des ouvertures 210 dans la couche isolante du support 2 pour accéder aux plages conductrices 21, et relier les deux faces du support 2.

Une fois effectué les connexions entre les bornes d'entrées-sorties 30 du composant semi-conducteur 3 et les plages 21, on enrobe l'arrière du support 2 à l'aide d'une résine, de manière à garantir une bonne tenue mécanique et, accessoirement, à l'isoler électriquement. On a représenté, sous la référence 4, la délimitation de l'enrobage.

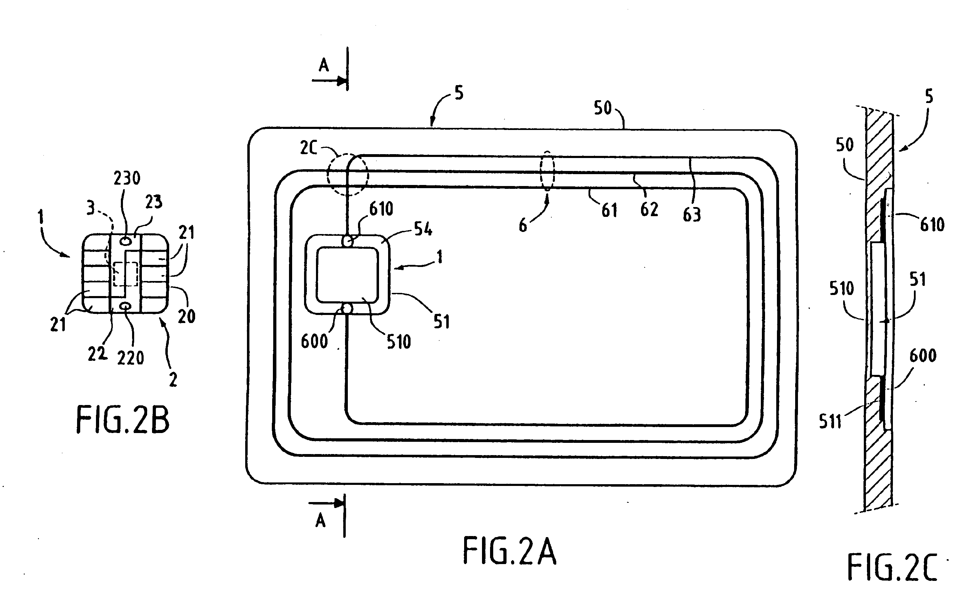

Jusqu'à présent, les opérations décrites sont tout à fait classiques et communes à l'art connu. Pour pouvoir connecter les extrémités de la boucle d'antenne 6 (terminaisons 600 et 610, figure 2A), on prévoit deux plages conductrices supplémentaires disposées dans la bande précitée du support 2, 22 et 23 respectivement. Ces plages sont avantageusement disposées, de façon symétrique, de part et d'autre du composant 3. On prévoit également deux ouvertures, 220 et 230 à travers le support, livrant accès aux faces opposées des plages conductrices. Les plages 22 et 23 sont électriquement isolées l'une de l'autre et des autres plages conductrices 21.

Selon une caractéristique importante de cette forme de réalisation de l'invention, au moins l'une des plages de contact, la plage de contact 22 dans l'exemple décrit sur la figure 1, s'étend depuis un bord du support 2 en direction du bord opposé, en passant au-dessus du composant semi-conducteur 3 jusqu'à atteindre approximativement le bord de la zone d'enrobage 4. Selon la figure 1, on voit que les deux plages conductrices 22,23 sont en forme de L dont une petite branche s'étend approximativement à l'extérieur de la zone d'enrobage 4, parallèlement au bord du support 2, et une grande branche s'étend en direction du bord opposé du support. Dans une variante de réalisation, la plage de contact 23 pourrait s'arrêter au voisinage du bord du composant semi-conducteur 3, sans passer au-dessus de celui-ci.

La plage de contact 22 comporte une ouverture 220', à l'intérieur de la zone d'enrobage 4, du côté opposé à l'ouverture 220. L'ouverture 220' joue, pour la borne d'entrée-sortie 31, le rôle des ouvertures 210. De même, la plage de contact supplémentaire 23 comporte une ouverture 230', à l'intérieur de la zone d'enrobage 4, mais située du même côté que l'ouverture 230. De ce fait, l'une des bornes d'entrée-sortie, la borne 31, peut être connectée à la plage métallisée 22-22' via un fil 310, alors que l'autre, la borne 32, peut être connectée à la plage métallisée 23 via un fil 320.

On va maintenant décrire un exemple de réalisation d'une carte à puce selon l'invention par référence aux figures 2A à 2C. La carte à puce 5 est de type mixte. Elle met en oeuvre un micromodule 1 du type illustré par la figure 1.

Ce dernier est représenté sur le figure 2B en vue de dessus, c'est-à-dire côté contacts électriques 21. Comme il a été indiqué, outre les plages de contact "classiques" 21, destinées à permettre un dialogue entre un organe du type "lecteur de carte" (non représenté), également classique, on a prévu deux plages supplémentaires, 22 et 23, pour connecter les terminaisons, 600 et 610, d'une antenne en boucle 6 (figure 2A).

On a supposé que la fréquence utilisée est choisie dans la gamme des hautes fréquences (13,56 MHz). L'antenne comprend au moins une spire, plus généralement deux ou trois, si la fréquence précitée est utilisée. Dans l'exemple décrit, on a supposé que l'antenne, référencée 6, comprend trois spires, 61 à 63. Cette antenne 6 est substantiellement plane, les spires, 61 à 63 étant concentriques et entourant avantageusement la zone où est placée le micromodule 1, de manière à présenter une surface la plus grande possible, et par là une sensibilité maximale. Dans l'exemple décrit, les spires 61 à 63 sont substantiellement rectangulaires, c'est-à-dire de même forme que la carte à puce 5.

La position du micromodule 1 est déterminée, a priori, par les spécifications des normes précitées, c'est-à-dire dans une zone située dans le quart gauche haut de la carte à puce (en vue de dessus, comme illustré par la figure 2A).

On prévoit, dans le corps 50 de la carte à puce 5, une cavité ouverte 51, dans laquelle est disposé le module 1. De façon plus précise, comme le montre la figure 2C (en vue de côté et en coupe selon AA de la figure 2A), cette cavité 51 comprend deux zones, une cuvette centrale 510, destinée à contenir le composant 3 et son enrobage en résine 4, et une gorge périphérique moins profonde 511, sur le fond de laquelle repose la périphérie du support 2. Les ouvertures, 220 et 230 sont disposées à l'aplomb du fond de la gorge périphérique 511.

Enfin, selon une caractéristique de l'invention, les terminaisons, 600 et 610 débouchent sur le fond de cette gorge 511. Elles prennent avantageusement la forme de plages conductrices relativement larges.

Il est donc aisé de réaliser une liaison entre ces plages de terminaison d'antenne 600 et 610, et les plages, 22 et 23, du support 2. La disposition adoptée par l'invention permet une grande tolérance de fabrication. On constate également qu'il n'y a, dans cette région centrale, qu'un niveau de métallisation.

L'établissement de la conductivité électrique entre le micromodule 1 et les extrémités de l'antenne 6 peut être obtenu par des moyens en soi classiques, et notamment : adhésif conducteur, élastomère conducteur, soudure, déformation et soudure thermique du métal du support 2 contre les plages 600 et 610.

La carte à puce 5 de la variante de réalisation qui vient d'être décrite en regard des figures 2A à 2C répond donc bien aux objectifs que s'est fixée l'invention.

Cependant, il subsiste un inconvénient. En effet, l'antenne 6 comporte, en général, un minimum de deux spires, voire plus. Quelle que soit la configuration adoptée, il existe obligatoirement, à un endroit ou à un autre de la surface de la carte à puce 5, un ou plusieurs croisements de pistes conductrices. Sur la figure 2A, on constate que la partie terminale de la spire 63 croise les spires 61 et 62, dans une zone référencée *ZC*. Pour éviter un court-circuit, il est nécessaire de prévoir une isolation entre ces différentes pistes conductrices. Ceci peut être réalisé en réalisant plusieurs niveaux de métallisation, par exemple, en prévoyant une couche isolante et un "pont" conducteur. Cette solution n'est cependant pas toujours satisfaisante.

Aussi selon un autre aspect de l'invention, on fait passer les tronçons intermédiaires des spires de l'antenne 6 entre ses terminaisons, 600 et 610, c'est-à-dire dans la zone centrale où se trouve la cavité 51.

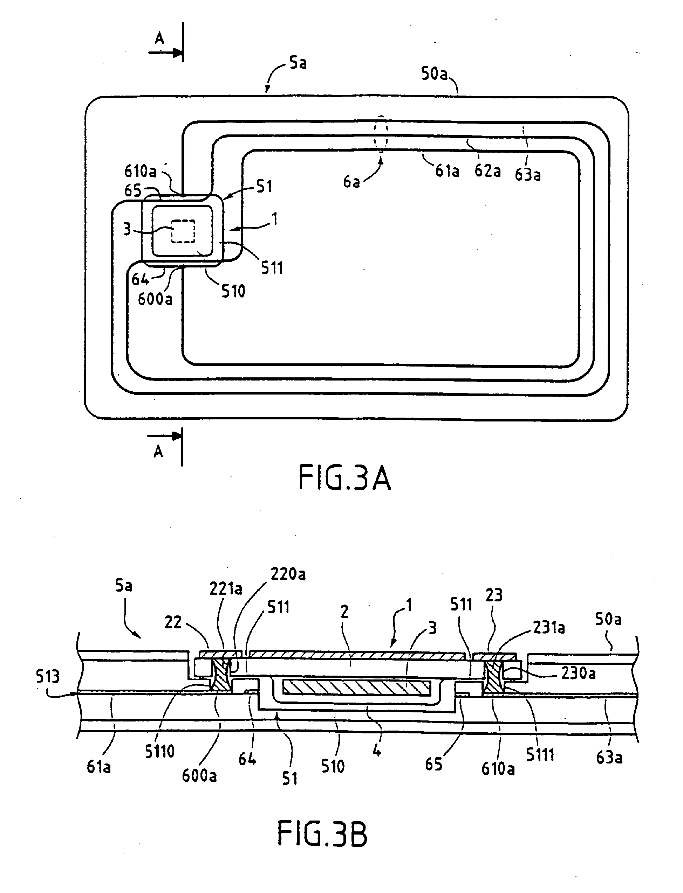

On va décrire une première variante selon ce second mode de réalisation, par référence aux figures 3A et 3B. La figure 3A illustre schématiquement la carte à puce, ici référencée 5*a*, en vue de dessus, et la figure 3B, illustre cette même carte à puce 5a, en vue de côté et en coupe selon AA de la figure 3A, le micromodule 1 étant assemblé.

Les éléments communs, ou pour le moins similaires, à ceux représentés sur les figures précédentes portent la même référence et ne seront re-décrits qu'en tant que de besoin. Ils sont toutefois associés à la lettre '*a*' s'il existe des modifications de structure.

Selon la caractéristique principale de ce mode de réalisation, les segments d'antenne 6*a* établissant une connexion entre deux spires successives, 61*a* à 63*a* par exemple, les segments 64 et 65 passent entre les terminaisons d'antenne 600*a* et 610*a*. De façon plus précise (figure 3B), on prévoit une métallisation des spires de l'antenne sur un niveau 513, intermédiaire entre le fond de la gorge périphérique 511 de la cavité 51, et le fond de la cuvette centrale 510 de cette cavité. Les terminaisons d'antenne débouchent sous la forme de deux plages, 600*a* et 610*a*, sous le fond de la gorge périphérique 511, et un contact est établi avec les plages de contact supplémentaires 22 et 23, respectivement. Les spires elles-mêmes, 61*a* à 63*a*, sont tracées également sur ce niveau, qui correspond à la face supérieure d'une couche de matériau plastique de la carte à puce 5*a*.

On prévoit des trous 5110 et 5111 dans le fond de la gorge périphérique 511 et à l'aplomb des plages conductrices supplémentaires, 22 et 23, respectivement, et des ouvertures correspondantes, 220a et 230a. Les connexions entre les plages de contact, 22 et 23, et les plages de terminaison d'antenne, 600*a* et 610*a*, sont physiquement réalisées par des plots conducteurs, 221a et 231a, respectivement. Ces plots sont réalisés, comme pour les figures 2A à 2C par différents moyens, et pourraient être remplacés, dans une variante de réalisation non représentée, par une déformation des plages de contact en direction des terminaisons d'antenne ou au contraire par une remontée de ces terminaisons vers les plages de contact.

Cette opération ne nécessite pas une grande précision. En effet, la couche en matériau isolant surplombant le niveau 513, sur lequel sont réalisées les métallisations d'antenne, peut être pré-percée, c'est-à-dire que l'on réalise les trous 5110 et 5111 dans la couche isolante avant d'appliquer celle-ci sur l'antenne, ce qui évite tout risque de détruire les plages, 600*a* et 610*a*. Ce risque serait réel, si le perçage était effectué après que la couche isolante ait été réalisée, par exemple par usinage au moyen d'un foret, l'épaisseur de la métallisation étant très faible. Typiquement, pour une épaisseur de carte d'environ 800 µm, l'épaisseur de la métallisation est de quelques dizaines de µm. Quant au diamètre des trous 5110 et 5111, il est de l'ordre du millimètre, tandis que leur profondeur est de l'ordre de 150 µm.

On suppose que la zone du niveau 513 de métallisation qui est située à l'aplomb du fond de la gorge périphérique 511 présente une largeur suffisante pour laisser le libre passage à au moins une piste supplémentaire entre le bord interne, donnant sur la cuvette centrale 510, et les plages 600*a* et 610*a* précitées.

Dans l'exemple décrit, le segment de piste conducteur 64 est disposé entre la terminaison 600*a* et le composant semi-conducteur 3, et le segment de piste conducteur 65 est disposé entre la terminaison 610*a* et ce même composant semi-conducteur 3. En d'autres termes, les segments 64 et 65 sont situés de part et d'autre du composant semi-conducteur 3. Dans une variante non représentée, les deux segments, 64 et 65, auraient pu être disposés du même côté du composant semi-conducteur 3, dans la mesure où l'espace laissé libre est suffisant.

On constate aisément que toutes les métallisations formant l'antenne sont rigoureusement dans un même plan, c'est-à-dire au niveau du fond de la gorge périphérique 511. Ce plan est avantageusement situé dans une région médiane, vu dans l'épaisseur de la carte, facilitant ainsi l'obtention d'une carte bien plane.

Le tracé de métallisation qui vient d'être décrit convient plus particulièrement lorsque le composant semi-conducteur 3 est relativement réduit en longueur. Dans le cas contraire, on préférera des variantes de réalisations supplémentaires qui vont maintenant être décrites.

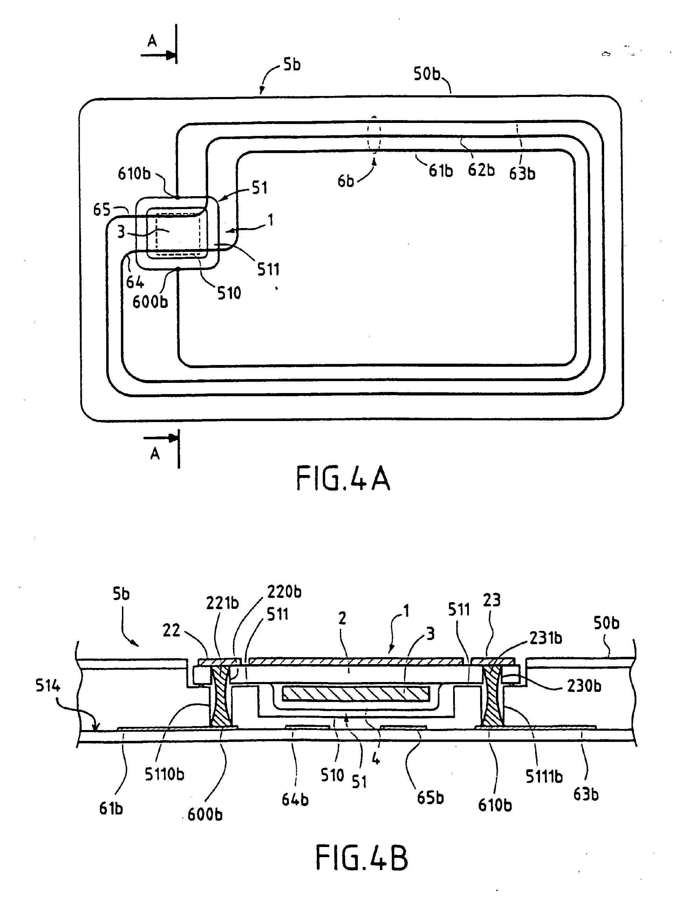

Une première variante de réalisation supplémentaire, va maintenant être décrite par référence aux figures 4A et 4B.

La figure 4A illustre schématiquement la carte à puce, ici référencée 5*b*, en vue de dessus, et la figure 4B, cette même carte à puce 5*a*, en vue de côté et en coupe selon AA de la figure 4A, le micromodule 1 étant assemblé.

Les éléments communs, ou pour le moins similaires, à ceux représentés sur les figures précédentes portent la même référence et ne seront re-décrits qu'en tant que de besoin. Ils sont toutefois associés à la lettre '*b*' s'il existe des modifications de structure.

Les segments de raccordement, 64*b* et 65*b*, entre spires, 61*b* à 63*b*, de l'antenne 6*b* passent sous le fond de la cavité 51, sur un plateau de niveau référencé 514. Les spires elles-mêmes, 61*b* à 63*b*, sont tracées également sur ce niveau, qui correspond à la face supérieure d'une des couches de matériau plastique de la carte à puce 5*b*. Les plots, 221*b* et 231*b*, sont légèrement plus longs que les plots, 221*a* et 231*a*, correspondants (figure 3B), ce qui ne constitue pas un inconvénient notable.

Il est clair que cet agencement permet une plus grande latitude de câblage, puisque l'on peut disposer de toute la surface du fond de la cavité 51, ce quelles que soient les dimensions du composant semi-conducteur 3. Comme précédemment, la métallisation de l'antenne 6*b* est réalisée sur un niveau unique (niveau 514).

Il subsiste cependant un inconvénient mineur, d'ordre esthétique. En effet, cette disposition ne laisse pas de place pour un matériau de type "PVC cristal", c'est-à-dire transparent à l'extérieur de la carte à puce, sauf à laisser visible les spires de l'antenne.

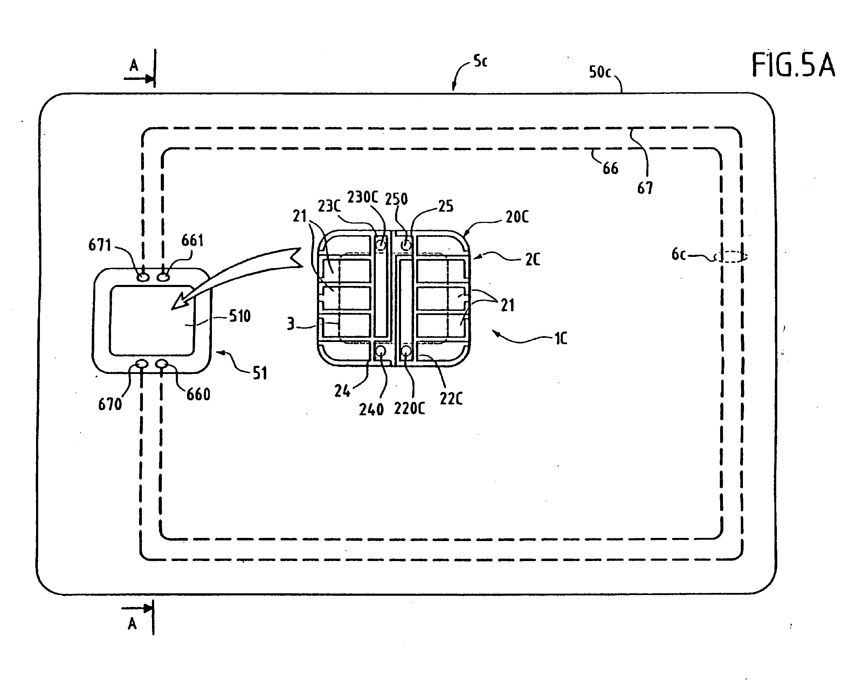

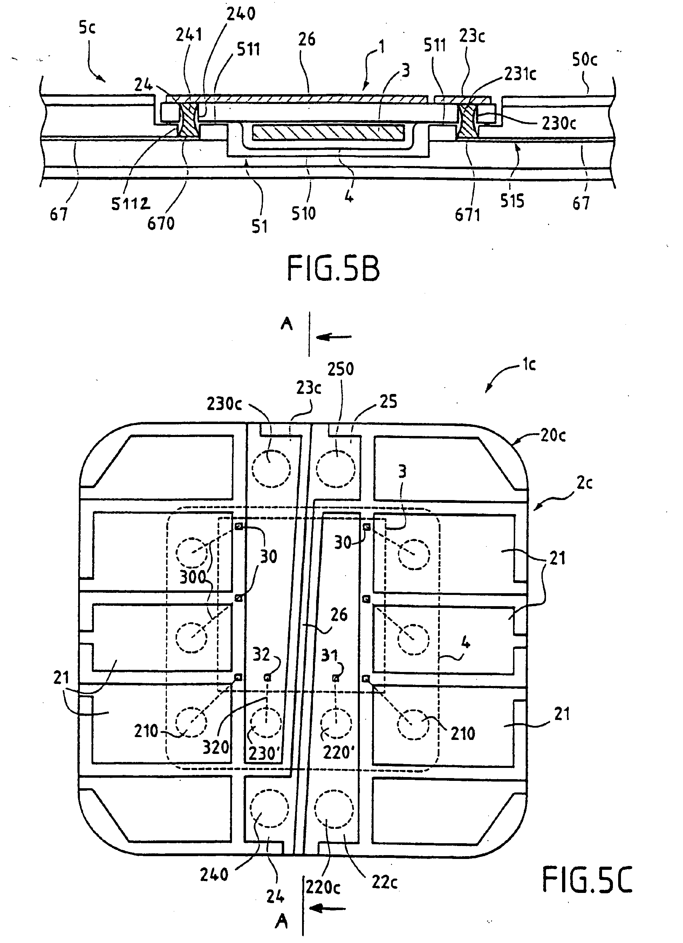

Une deuxième variante de réalisation supplémentaire, permettant de pallier cet inconvénient, est décrite par référence aux figures 5A à 5C. La figure 5A illustre schématiquement la carte à puce, ici référencée 5*c*, en vue de dessus, et la figure 5B illustre cette même carte à puce, en vue de côté et en coupe selon AA de la figure 5A, le micromodule, ici référencé 1*c*, étant assemblé. La figure 5C illustre, en vue de dessus, c'est-à-dire côté contacts conducteurs, ce micromodule 1*c*, modifié pour convenir à cette variante de réalisation particulière.

Les éléments communs, ou pour le moins similaires, à ceux représentés sur les figures précédentes portent la même référence et ne seront re-décrits qu'en tant que de besoin. Ils sont toutefois associés à la lettre '*c*' s'il existe des modifications de structure.

Dans l'exemple décrit, on a supposé que l'antenne, ici référencée 6c, comprenait deux spires 66 et 67. Ces deux spires sont coupées, de façon à ce que leurs extrémités puissent être interconnectées sur des plages de contact du support 2*c*.

En effet, selon la caractéristique principale de cette deuxième variante de réalisation supplémentaire, la connexion entre spires, 66 et 67, est réalisée par l'intermédiaire d'une plage métallisée 26 réalisée directement sur le support 2*c*.

Les pistes métallisées formant les spires 66 et 67, de l'antenne 6*c* peuvent être réalisées de la manière décrite en regard de la figure 3B, c'est-à-dire sur un plateau de niveau 515 situé à un niveau intermédiaire entre le fond de la cuvette centrale 510 de la cavité 51 et le fond de la gorge périphérique 511 de cette même cavité, c'est-à-dire sur la surface d'une des couches en matériau plastique constituant le corps 50*c* de la carte à puce 5*c*.

L'une des extrémités, 660 ou 671, des spires, 66 ou 67, de l'antenne 6*c*, ou terminaisons d'antenne, est connectée au micromodule 1*c* de façon similaire, sinon identique, à ce qui a été décrit pour la variante décrite en regard de la figure 3B précitée, via deux plages de contact, 22*c* ou 23*c*, et des ouvertures, 220*c* ou 230*c*, respectivement.

Par contre, on réalise une plage de contact comportant deux zones larges 24,25 reliées par une zone mince et allongée 26. Les zones 24 et 25 sont situées l'une à droite (sur la figure 5C), l'autre à gauche des plages de connexion d'antenne 22c et 23 c, entre les plages de contact 21. Dans une variante non représentée, la zone 26 pourrait être dotée d'une plus grande largeur, en réduisant l'étendue des plages 22c et 23c. Les connexions entre les zones 24 et 25 et les terminaisons d'antenne 670 et 661, s'effectuent via les ouvertures, 240 et 250, des trous dans la couche isolante surplombant le niveau de métallisation 515 (dont un, 5112, est visible sur la figure 5B) et des plots conducteurs (dont un, 241, est visible sur la figure 5B)

I1 doit être clair que, bien que les pistes, 66 et 67, de l'antenne 6*c* soient réalisées sur un premier niveau (plateau 515), et les zones 24-25-26 entre deux spires sur un second niveau, on ne crée pas pour autant un niveau de métallisation supplémentaire. En effet, le niveau d'interconnexion 24-25-26 est commun au niveau de métallisation déjà utilisé pour les plages de contact, 21 à 23 (surface supérieure de la pastille support 2c).

On peut également imaginer, dans une variante non illustrée, réaliser plusieurs métallisations de connexion du type 26, reliant des paires de plages de contact supplémentaires. Par ce biais, on pourra interconnecter plus de deux spires successives. On réalise cependant que, dans la pratique, le nombre d'interconnexions possibles, réalisées entre les paires de contacts 22 et 23, est très limité. Cette variante s'accommode cependant parfaitement d'une configuration d'antenne à deux ou trois spires, ce qui est généralement le cas pour une fréquence de 13,56 MHz.

A la lecture de ce qui précède, on constate aisément que l'invention atteint bien les buts qu'elle s'est fixés.

Il doit être clair cependant que l'invention n'est pas limitée aux seuls exemples de réalisations explicitement décrits, notamment en relation avec les figures 1 à 5C.

En particulier, les valeurs numériques n'ont été précisées que pour fixer les idées. Elles dépendent essentiellement de l'application précise visée. Les matériaux utilisables sont ceux généralement mis en oeuvre dans le domaine. En ce sens, l'invention reste compatible avec les technologies courantes, ce qui est un avantage supplémentaire.

L'invention s'applique préférentiellement aux cartes à puce de type "mixte", mais ne saurait en aucun cas être limitée à cette seule application. Elle s'applique également aux cartes à puce sans contacts, même si les avantages que l'on peut en retirer sont moindres que dans le premier cas.

En effet, les avantages présentés par l'invention sont nombreux, notamment pour les cartes à puces de type "mixte", et parmi lesquels les suivants :
- faible coût de revient ;
- utilisation d'un support (circuit imprimé) de composant semi-conducteur simple face ;
- accès direct aux contacts supplémentaires, et donc de ce fait à l'interface haute fréquence, ce qui permet d'effectuer des tests électriques par contact sur la connectique d'antenne et de tester les entrées-sorties de cette interface ;
- compatibilité parfaite avec les procédés mis en oeuvre dans l'art connu pour la fabrication des micromodules et l'encartage ; et
- les cavités spécifiques ménagées pour l'accès aux terminaisons d'antenne autorisent une tolérance importante sur le volume de matériau conducteur utilisé pour réaliser les plots de connexion.

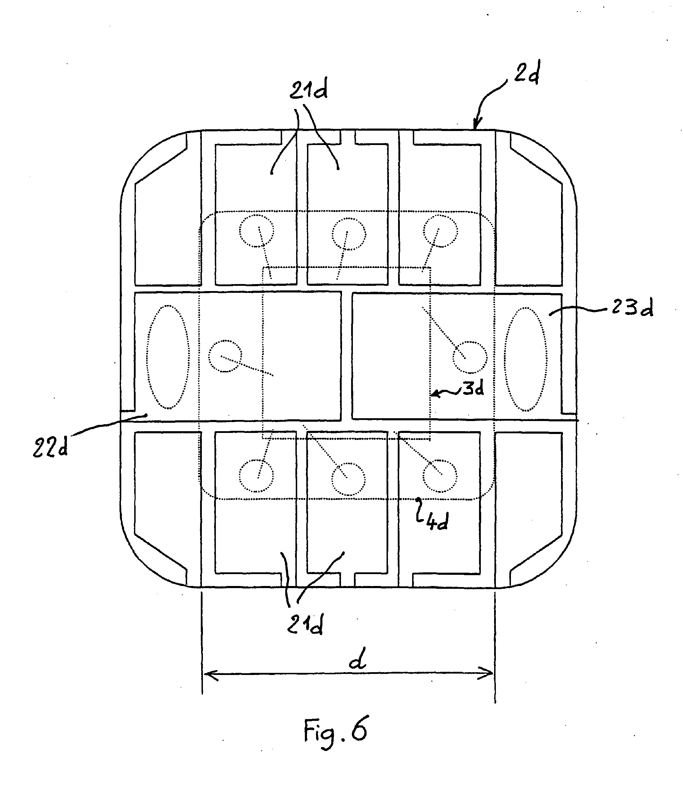

Dans une variante de réalisation, les bornes d'entrée et/ou de sortie de l'interface haute fréquence du composant semi-conducteur ne sont pas groupées sur un même côté du composant, mais réparties sur deux côtés opposés. Selon cette variante, les liaisons avec les plages de contact se font de part et d'autre du composant semi-conducteur. La plage de contact 22 (figure 1) ne s'étend donc plus nécessairement au-dessus du composant semi-conducteur. En somme, les plages de contact 22,23 peuvent s'étendre sensiblement entre un bord du composant semi-conducteur 3 et un bord du support 2 lui faisant face. Toutefois, de préférence, on adoptera la configuration de la figure 6 où les plages de contact 22d et 23d s'étendent respectivement, depuis un bord du support 2d vers une région médiane du composant semi-conducteur 3d, de façon à recouvrir sensiblement toute la région centrale située entre les deux rangées de plages de contact 21d. On notera cependant que, pour ne pas augmenter trop la largeur d de la zone d'enrobage 4d et ménager ainsi une largeur suffisante pour le collage latéral du support 2d, on réservera de préférence l'agencement de la figure 6 à des composants semi-conducteurs moins larges que celui de la figure 1.

Cette variante de réalisation peut naturellement s'appliquer aux modes de réalisation décrits en regard des figures 3A-3B, 4A-4B et 5A-5C.

## Revendications

1. Micromodule comportant un support isolant ayant une face isolante, un composant semi-conducteur ayant deux points de connexion électrique accessibles sur ladite face isolante, lesdits points connectant ou destinés à connecter deux extrémités (600a, 610a) d'une antenne externe en forme de boucle (6),
**caractérisé en ce que** lesdits deux points de connexion (22,23) sont disposés dans une bande de la face isolante passant par une région centrale de ladite face isolante, ladite bande s'étendant longitudinalement d'un bord de la face isolante vers le bord opposé.

2. Support à base de couches électriquement isolantes, tel une carte à puce, ledit support logeant le micromodule (1) conforme à la revendication 1.

## Claims

1. Micromodule comprising an insulating support having an insulating face, a semiconductor component having two electric connecting points accessible on said insulating face, said points connecting or intended to connect two ends (600a, 610a) of an antenna in the form of loop (6),
**characterized in that** said two connecting points (22,23) are laid out in a band of the insulating face passing by a central area of said insulating face, said band extending longitudinally from an edge of the insulating face towards the opposite edge.

2. Support containing electrically insulated layers, such as smart card, said support comprising the micromodule (1) according to claim 1.

## Patentansprüche

1. Mikromodul mit einem eine Isolierseite aufweisenden Isolierträger, einem Halbleiterbaustein mit zwei auf dieser Isolierseite zugänglichen elektrischen Anschlussstellen, wobei die besagten Anschlussstellen zwei Enden (600a, 610a) einer in Schleifenform ausgebildeten externen Antenne (6) verbinden oder für die Verbindung derselben bestimmt sind,
**dadurch gekennzeichnet, dass** die beiden Anschlussstellen (22,23) auf der Isolierseite in einem Band angebracht sind, welches durch einen mittigen Abschnitt der Isolierseite verläuft und sich längs von einem Rand der Isolierseite zum entgegengesetzten Rand erstreckt.

2. Träger auf Basis elektrisch isolierender Schichten, gleich einer Chipkarte, wobei das erfindungsgemäße Mikromodul (1) nach Anspruch 1 im besagten Träger untergebracht ist.
